# EUROPEAN PATENT APPLICATION

(11) **EP 2 416 638 A2**
(43) Date of publication of application: **08.02.2012**
(21) Application number: 11175968.4
(22) Date of filing: 29.07.2011
(51) Int. Cl.: H05K 7/20

(54) **Electronic Device**

(30) Priority: 02.08.2010 JP 2010173858; 08.10.2010 JP 2010228710; 26.04.2011 JP 2011098682
(71) Applicant: Fuji Electric Holdings Co., Ltd., Kawasaki-shi, Kanagawa 210-9530 (JP)
(72) Inventor: Shintani, Takanori, Kawasaki-shi, 210-9530 (JP)
(74) Representative: Appelt, Christian W.

(57) **Abstract**

To provide an electronic device provided with a higher waterproofing performance, without causing a problem caused by heat emitted by an electronic part. A inverter that accommodates an electronic part in the interior of a housing is such that, while a ventilation duct is defined in an up-down direction in a front wall portion configuring a wall of the housing, and a ventilation hole that allows the ventilation duct to communicate with the exterior of the housing is formed in the lower end portion of the ventilation duct, a ventilation opening that allows the ventilation duct to communicate with the interior of the housing is formed in a position higher than the ventilation hole.

## Description

### BACKGROUND OF THE INVENTION

### 1. Technical Field

The present invention relates to an electronic device, and in particular, relates to a structure that counteracts heat emission in a housing interior.

### 2. Related Art

In an electronic device that accommodates an electronic part in the interior of a housing, a ventilation opening is formed in the housing in order to prevent a problem caused by heat emitted by the electronic part being shut up in the interior. As this kind of ventilation opening, one including a louver has also been provided. According to an electronic device in which the ventilation opening includes a louver, it is possible to prevent water, such as rain water, from easily leaking into the housing interior, even when the device is installed outdoors (for example, refer to JP-A-2002-151874).

However, a waterproofing structure formed by providing a ventilation opening with a louver is extremely simple, and it is difficult to prevent water from leaking into the housing interior when, for example, a jet of water is sprayed onto the outer surface of the housing.

### SUMMARY OF THE INVENTION

The invention, bearing in mind the heretofore described fact, has an object of providing an electronic device provided with a higher waterproofing performance, without causing a problem caused by heat emitted by an electronic part.

In order to achieve the object, an electronic device according to an aspect of the invention accommodates an electronic part in the interior of a housing, wherein, while a ventilation duct is defined in a vertical or in an up-down direction in a surface member configuring a wall of the housing, and a ventilation hole that allows the ventilation duct to communicate with the exterior of the housing is formed in the lower end portion of the ventilation duct, a ventilation opening that allows the ventilation duct to communicate with the interior of the housing is formed in a position higher than the ventilation hole.

Also, in the electronic device according to the aspect of the invention, a maze reaching the ventilation opening from the ventilation hole is configured by disposing a dividing wall in the interior of the ventilation duct.

Also, in the electronic device according to the aspect of the invention, a maze wherein the ventilation hole and ventilation opening are communicated between by detouring to the left or right is configured by vertically disposing a plurality of dividing walls forming plate forms in the horizontal direction, and maintaining a gap in each dividing wall row by displacing the left-right position.

Also, in the electronic device according to the aspect of the invention, a maze wherein the ventilation hole and ventilation opening are communicated between by detouring to the left or right is configured by disposing left to right a plurality of dividing walls forming an irregular form in a condition in which a gap is maintained between the dividing walls.

Also, in the electronic device according to the aspect of the invention, the housing is configured as a cuboid with a large height in comparison with the width dimension in the left-right direction, and the ventilation duct is defined in a surface member configuring the front surface of the housing.

Also, in the electronic device according to the aspect of the invention, by providing a duct cover on the inner surface of a surface member configuring a wall of the housing, the ventilation duct is defined between the surface member and duct cover, and the ventilation hole is formed in the lower end portion of the surface member.

Also, in the electronic device according to the aspect of the invention, the ventilation hole is configured by opening a plurality of rectangular holes with a comparatively small aperture area, and the ventilation opening is configured by opening only one rectangular hole with a comparatively large aperture area in the duct cover.

Also, in the electronic device according to the aspect of the invention, a water-impermeable plate is provided in a region wherein it covers the front region of the ventilation hole.

Also, in the electronic device according to the aspect of the invention, the ventilation hole is configured by arranging in parallel left to right a plurality of slits opened in the up-down direction, and at least in a surface facing the bottom of the housing, and the ventilation opening is formed between the surface member and the upper edge portion of the duct cover.

Also, in the electronic device according to the aspect of the invention, an exhaust opening communicating between the interior and exterior of the housing is formed in the upper end portion of a surface member opposing the surface member of the housing in which the ventilation hole is provided.

Also, in the electronic device according to the aspect of the invention, by providing a duct cover on the outer surface of a surface member configuring a wall of the housing, the ventilation duct is defined between the surface member and duct cover, the ventilation opening is formed in the surface member, and the ventilation hole is formed between the surface member and the lower end portion of the duct cover.

Also, in the electronic device according to the aspect of the invention, a depressed portion having a top wall is formed in the outer surface of the surface member, the ventilation duct is defined by covering the depressed portion with the duct cover, and the ventilation opening is provided in the top wall of the depressed portion.

Also, in the electronic device according to the aspect of the invention, an exhaust opening communicating between the interior and exterior of the housing is formed in the upper end portion of a surface member opposing the surface member of the housing in which the ventilation opening is provided.

Also, in the electronic device according to the aspect of the invention, the exhaust opening is formed in a position higher than the ventilation opening.

Also, in the electronic device according to the aspect of the invention, a rib is installed protruding in a region positioned on the upper edge of the exhaust opening in at least the exterior of the housing.

According to the invention, as it is possible to carry out ventilation in the interior and exterior of the housing via the ventilation duct, there is no danger of causing a problem caused by heat emitted by the electronic part being shut up in the interior. Moreover, in the ventilation duct, the ventilation opening opened onto the interior of the housing is formed in a position higher than the ventilation hole opened onto the exterior of the housing. Consequently, even supposing that a jet of water leaks into the interior of the ventilation duct through the ventilation hole, the probability of the water reaching the interior of the housing directly through the ventilation opening is extremely low, and it is possible to secure a higher waterproofing performance.

### BRIEF DESCRIPTION OF THE DRAWINGS

Fig. 1 is a perspective view showing an external appearance of an electronic device, which is a first embodiment of the invention;
Fig. 2 is a perspective view of a condition in which a water-impermeable plate is removed from the electronic device shown in Fig. 1;
Fig. 3 is a sectional side view of the electronic device shown in Fig. 1;
Fig. 4 is a perspective view showing a duct cover for defining a ventilation duct in the electronic device shown in Fig. 1;
Fig. 5 is a diagram of the duct cover shown in Fig. 5 seen from the ventilation duct side;
Fig. 6 is a perspective view showing an external appearance of an electronic device, which is a second embodiment of the invention;
Fig. 7 is an exploded perspective view of the electronic device shown in Fig. 6;
Fig. 8 is a sectional side view of the electronic device shown in Fig. 6;
Fig. 9 is a diagram of a duct cover for defining a ventilation duct in the electronic device shown in Fig. 6, seen from the ventilation duct side;
Fig. 10 is a perspective view showing an external appearance of an electronic device, which is a third embodiment of the invention;
Fig. 11 is an exploded perspective view of the electronic device shown in Fig. 10;
Fig. 12 is a sectional side view of the electronic device shown in Fig. 10;
Fig. 13 is a perspective view of a duct cover for defining a ventilation duct in the electronic device shown in Fig. 10; and
Fig. 14 is a diagram of the duct cover shown in Fig. 13 seen from the ventilation duct side.

### DESCRIPTION OF THE PREFERRED EMBODIMENT(S)

Hereafter, a detailed description will be given, referring to the attached drawings, of preferred embodiments of an electronic device according to the invention.

### First Embodiment

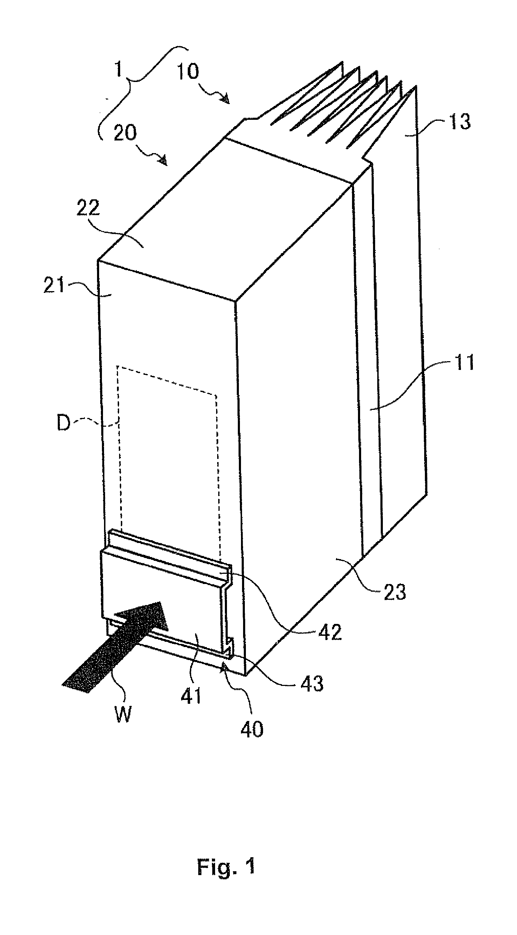

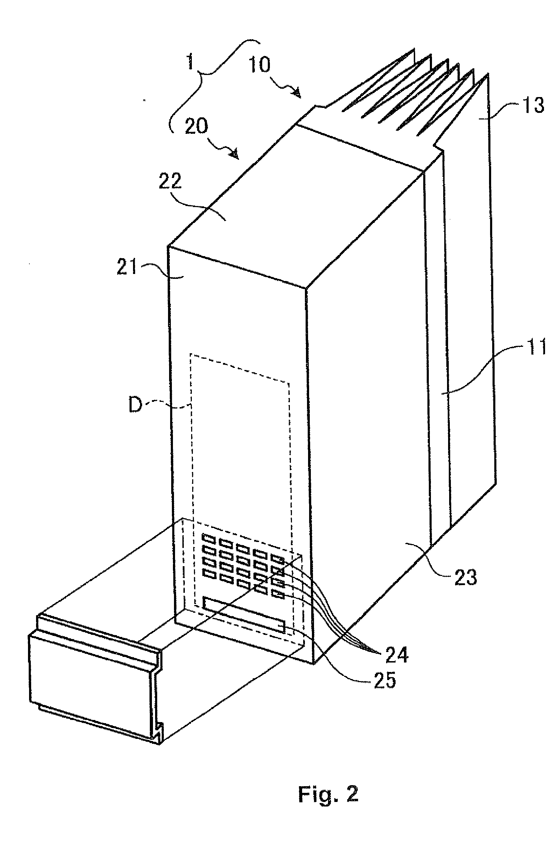

Figs. 1 and 2 show an external appearance of an electronic device, which is a first embodiment of the invention. The electronic device shown as an example here is an inverter that converts direct current to alternating current, and configures a housing 1 including a base member 10 and a cover member 20.

The base member 10, as shown in Figs. 1 to 3, includes a part mounting plate portion 11 forming a rectangular plate form on whose inner surface is mounted an electronic part E, a conduit frame portion 12 provided on a lower end portion of the part mounting plate portion 11, and a plurality of cooling fins 13 provided on the outer surface of the part mounting plate portion 11. The part mounting plate portion 11 and cooling fins 13 are integrally formed of a metal with comparatively high thermal conductivity, such as aluminum or an aluminum alloy. The conduit frame portion 12 is for disposing an unshown conduit connector from the interior to the exterior of the housing 1. The conduit frame portion 12 is provided in such a way as to protrude from the inner surface of the lower end portion of the part mounting plate portion 11 toward a side opposite to that of the cooling fins 13. As is also clear from the drawings, the part mounting plate portion 11 of the base member 10 is configured vertically long, with the height dimension being large in comparison with the width dimension in the left-right direction.

The cover member 20 covers the inner surface of the base member 10 in a condition in which an accommodation space for accommodating the electronic part E is secured between the cover member 20 and base member 10. The cover member 20 has a front wall portion (a surface member configuring the front surface of the housing) 21, an upper wall portion 22, and a pair of side wall portions 23 and 23. The front wall portion 21 is a portion disposed opposing the part mounting plate portion 11 of the base member 10. The front wall portion 21 is formed in a rectangular form having a width approximately equivalent to that of the part mounting plate portion 11. The upper wall portion 22 is a portion disposed opposing the conduit frame portion 12 of the base member 10. The upper wall portion 22 extends bent from the upper end edge of the front wall portion 21 toward the inner surface side of the front wall portion 21. The pair of side wall portions 23 and 23 are portions that extend bent, one from each of the two side edges of the front wall portion 21, toward the inner surface side of the front wall portion 21.

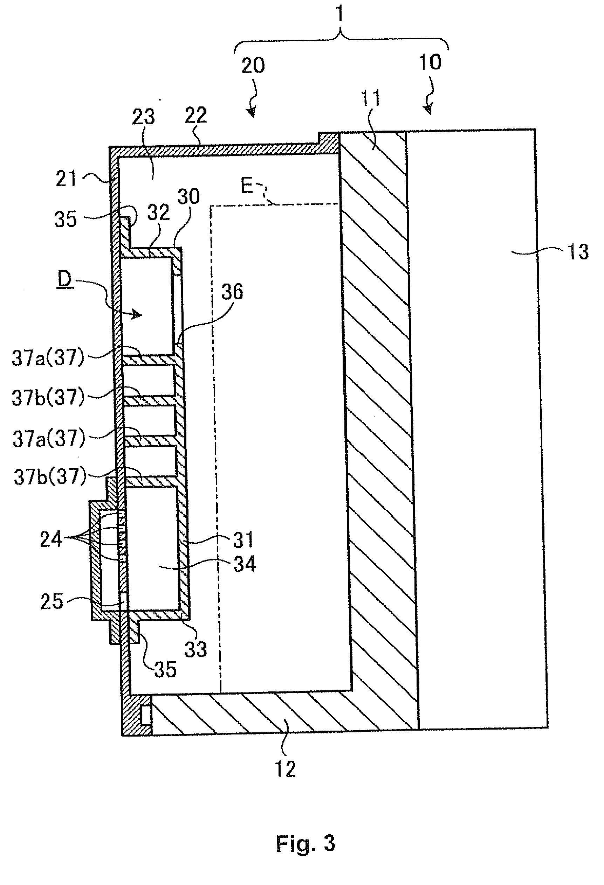

In the cover member 20, a plurality of ventilation holes 24 and a single drainage slit 25 are provided in the front wall portion 21, and a duct cover 30 is provided on the inner surface of the front wall portion 21, as shown in Figs. 2 and 3.

The ventilation holes 24 are horizontally long rectangular apertures, each of which penetrates the front wall portion 21. Each of the ventilation holes 24 is formed in the lower end portion of the front wall portion 21. The height dimension in the front-back direction and width dimension in the left-right direction of each ventilation hole 24 are set to a sufficiently small value with respect to the front wall portion 21. To give a specific description, in the first embodiment, even when five ventilation holes 24 are arranged in parallel in the left-right direction, the width dimension in the left-right direction is set so that the total width of the ventilation holes 24 is a width smaller than the overall width of the front wall portion 21.

The drainage slit 25 is a horizontally long rectangular aperture whose height dimension and width dimension are configured larger than those of the ventilation holes 24. The drainage slit 25 is formed so as to penetrate the front wall portion 21 in a region lower still than that of the ventilation holes 24 provided in the lowest row.

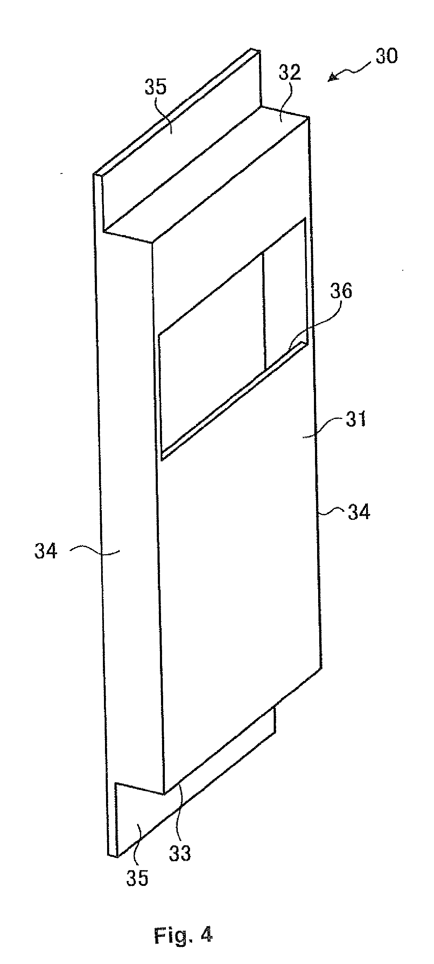

The duct cover 30 is for defining a ventilation duct D in the up-down direction in the front wall portion 21. As shown in Fig. 4, the duct cover 30 is configured in a cuboid form having a rear surface plate portion 31, an upper surface plate portion 32, a lower surface plate portion 33, and a left-right pair of side surface plate portions 34 and 34. An attachment piece portion 35 is provided parallel to the rear surface plate portion 31 on each of the upper surface plate portion 32 and lower surface plate portion 33. The duct cover 30 is attached via the attachment piece portions 35 to the inner surface of the front wall portion 21 in a position such that the drainage slit 25 provided in the front wall portion 21 is above the upper surface of the lower surface plate portion 33, as shown in Fig. 3. Although not shown in the drawing, it is preferable that a gasket is interposed between the bonding surfaces of the cover member 20 and duct cover 30.

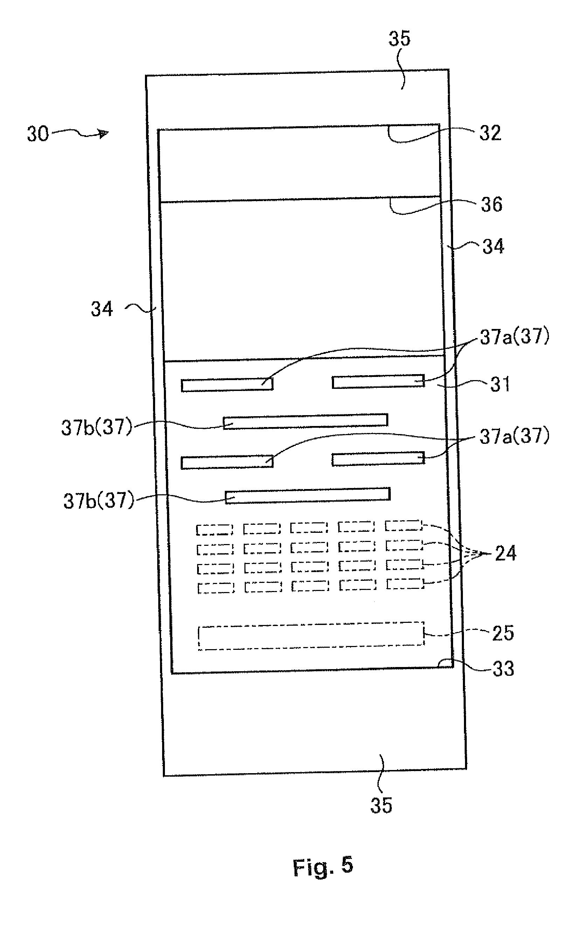

In the duct cover 30, a ventilation opening 36 is formed in a region positioned on the upper side of the rear surface plate portion 31, and a plurality of dividing walls 37 are provided on an inner surface of the rear surface plate portion 31 opposing the front wall. The ventilation opening 36 is a rectangular aperture formed in a region across the whole width of the rear surface plate portion 31. The ventilation opening 36 is provided in such a way that the height of the lower end edge thereof is positioned sufficiently higher than the upper end edge of the ventilation holes 24 of the front wall portion 21 provided in the highest position thereof. The dividing walls 37 configure a maze between the lower end edge of the ventilation opening 36 and the upper end edge of the ventilation holes 24 of the front wall portion 21 provided in the highest position thereof, wherein the ventilation opening 36 and ventilation holes 24 are communicated between by detouring to the left or right as shown in Fig. 5. Specifically, two first dividing walls 37a of a small length are arranged in parallel in a horizontal direction in positions below the lower end edge of the ventilation opening 36. A gap is maintained between the first dividing walls 37a, and between the first dividing walls 37a and the ventilation duct D side surface plate portions 34 and 34. Next, one second dividing wall 37b with a large length is disposed in a horizontal direction in a position below the first dividing walls 37a in such a way as to cover the gap maintained between the first dividing walls 37a from below. Each end portion of the second dividing wall 37b is positioned in a central portion of one of the first dividing walls 37a. Subsequently, two first dividing walls 37a are again arranged in parallel in positions below the second dividing wall 37b, and a second dividing wall 37b is disposed below the first dividing walls 37a. Owing to the heretofore described configuration, it is necessary to pass around four rows of dividing walls 37 to reach the ventilation opening 36 from the ventilation holes 24.

Furthermore, a water-impermeable plate 40 is provided in a lower portion of the front surface of the front wall portion 21 of the cover member 20, as shown in Figs. 1 to 3. The water-impermeable plate 40 is such that a water-impermeable portion 41 forming a rectangular plate of a size sufficient to cover the ventilation holes 24 and drainage slit 25 provided in the front wall portion 21, and an upper cover portion 42 and lower cover portion 43 that, after extending bent in the same direction as each other one from each of the top and bottom edge portions of the water-impermeable portion 41, extend bent in mutually opposite directions, are formed integrally. The water-impermeable plate 40 is attached to the front wall portion 21 via the upper cover portion 42 and lower cover portion 43 in such a way that a gap is maintained between the front wall portion 21 and water-impermeable portion 41, and that the water-impermeable portion 41 covers the front region of the ventilation holes 24 and drainage slit 25.

The cover member 20 configured as heretofore described, by covering the base member 10 in a condition in which each of the extended end portion of the upper wall portion 22 and extended end portions of the pair of side wall portions 23 and 23 is joined to the inner surface of the part mounting plate portion 11, and each of the lower end edge portion of the front wall portion 21 and lower end edge portions of the pair of side wall portions 23 and 23 is joined to the outer edge surface of the conduit frame portion 12, configures the housing 1 of the inverter in which an accommodation space for the electronic part E is secured between the cover member 20 and inner surface of the part mounting plate portion 11. Although not shown in the drawings, it is preferable that water tightness is secured by a gasket being interposed between the bonding surfaces of the cover member 20 and base member 10.

Herein, in this inverter, the interior and exterior of the housing 1 are in constant communication via the ventilation holes 24 of the front wall portion 21, ventilation duct D, and ventilation opening 36 of the ventilation duct D, even when water tightness is secured between the bonding surfaces of the cover member 20 and base member 10. Consequently, when the electronic part E emits heat due to the inverter being driven, not only is the heat released through the part mounting plate portion 11 and cooling fins 13, but also heat in the interior of the housing 1 is expelled to the exterior by air circulating via the ventilation opening 36, ventilation duct D, and ventilation holes 24, and there is no danger of causing a situation wherein heat is shut up in the interior of the housing 1.

Moreover, while the ventilation duct D communicating between the interior and exterior of the housing 1 opens onto the interior of the housing 1 via the ventilation opening 36 provided in the upper portion of the ventilation duct D, the ventilation duct D communicates with the exterior of the housing 1 via the ventilation holes 24 and drainage slit 25 provided in the lower portion of the ventilation duct D. Furthermore, not only are the plurality of dividing walls 37 that cause detours between the ventilation opening 36 and ventilation holes 24 provided in the interior of the ventilation duct D, but also the front region of the ventilation slits 24 and drainage slit 25 opening on the exterior are covered by the water-impermeable plate 40.

Consequently, even when a jet of water is sprayed from in front of the cover member 20, as shown by a wide arrow W in Fig. 1, there is no danger of a situation occurring wherein the jet of water reaches the interior of the housing 1. Even supposing that a jet of water is sprayed from the side of the cover member 20 so as to avoid the water-impermeable plate 40, there is hardly any danger of the jet of water leaking into the interior of the ventilation duct D from the ventilation holes 24 and drainage slit 25 opening frontward, and it does not, of course, reach the interior of the housing 1. A jet of water leaking into the interior of the ventilation duct D from the ventilation holes 24 and drainage slit 25 is expelled to the exterior via the drainage slit 25, and it does not happen either that the jet of water continuously builds up in the interior of the ventilation duct D.

Because of this, it is possible to provide a higher waterproofing performance in the inverter, without causing any problem due to heat emitted by the electronic part E.

Although an inverter is given as an example of the electronic device in the first embodiment, it is, of course, possible to apply the invention to another electronic device too, provided that it is an electronic device that accommodates the electronic part E in the interior of the housing 1.

Also, in the first embodiment, as a maze through which the ventilation opening 36 is reached from the ventilation holes 24 by detouring to the left and right is configured by disposing the dividing walls 37 in the interior of the ventilation duct D, and furthermore, as the water-impermeable plate 40 is provided in a region covering the front region of the ventilation holes 24, it is possible to secure greater waterproofing. However, it is possible to secure sufficient waterproofing without providing the maze formed by the dividing walls 37 or the water-impermeable plate 40, provided that the ventilation opening is formed in a position higher than the ventilation holes.

Furthermore, in the first embodiment, the ventilation duct D is provided in only the front wall portion 21 of the cover member 20 configuring the housing 1. However, the ventilation duct may be provided in only the side wall portions 23, or provided in both the front wall portion 21 and side wall portions 23, provided that it is provided somewhere other than in the upper wall portion 22.

### Second Embodiment

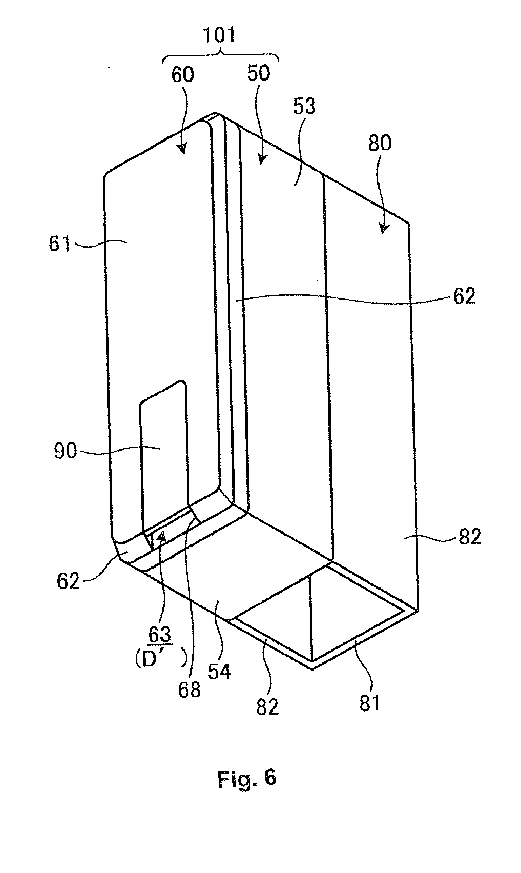

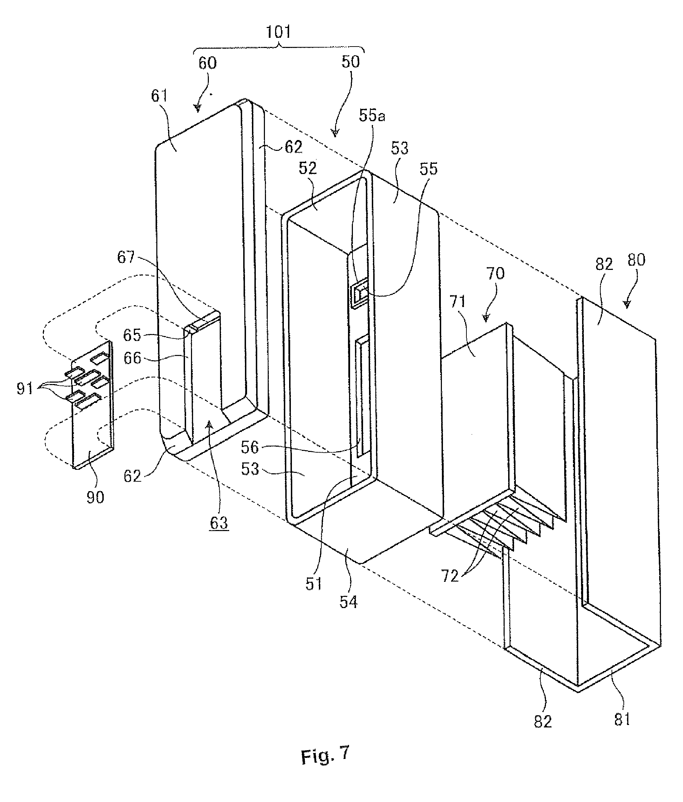

Figs. 6 and 7 show an external appearance of an electronic device, which is a second embodiment of the invention. The electronic device shown as an example here is an inverter that converts direct current to alternating current, and configures a housing 101 including a base member 50 and a cover member 60.

The base member 50, as shown in Figs. 6 to 8, forms a hollow cuboid form whose front surface is opened, and is configured vertically long, with the height dimension being large in comparison with the width dimension in the left-right direction and depth dimension in the front-back direction. In the base member 50, the inner surface of a rear wall portion (a surface member opposing a front wall portion (surface member) 61 of the housing 101, in which a ventilation opening 67, to be described hereafter, is provided) 51 positioned in the rear surface thereof is a part mounting surface for mounting an electronic part E'. In the base member 50, an upper wall portion 52, left and right side wall portions 53, and bottom wall portion 54 are formed integrally with the rear wall portion 51 so as to cover the periphery of the electronic part E' .

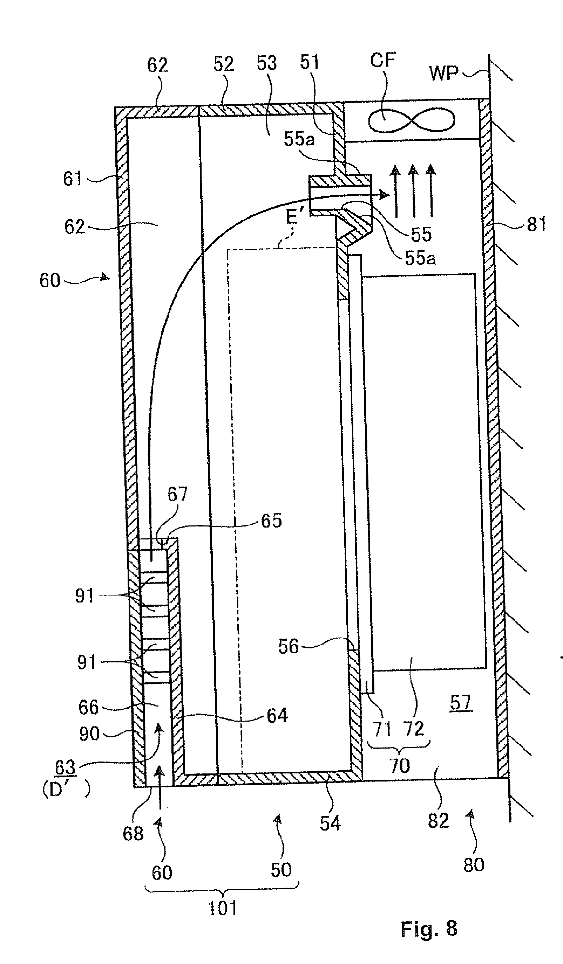

As shown in Figs. 7 and 8, an exhaust opening 55 is provided in the upper edge portion of the rear wall portion 51 of the base member 50, and a cooling fin 70 is attached to the central portion of the rear wall portion 51. The exhaust opening 55 is a slit-like aperture, horizontally long in the left-right direction. The exhaust opening 55 is formed in such a way as to penetrate the rear wall portion 51 from front to back. Ribs 55a are provided on the aperture edge portion of the exhaust opening 55. The ribs 55a are formed continuously on the whole perimeter of the exhaust opening 55 so as to protrude from both the front and rear surfaces of the rear wall portion 51. The ribs 55a provided on the upper edge portion and both side edge portions of the exhaust opening 55 protrude in a direction approximately perpendicular to the rear wall portion 51, and function as eaves guarding the exhaust opening 55 from water. Meanwhile, the rib 55a provided on the lower edge portion of the exhaust opening 55 is such that a portion positioned in the interior of the housing 101 protrudes in a direction approximately perpendicular to the rear wall portion 51. Meanwhile, the rib 55a provided on the lower edge portion of the exhaust opening 55 is such that a portion positioned in the exterior of the housing 101 is of a form inclined progressively downward toward the exterior and, when water adheres, has a function of guiding the water to the exterior of the housing 101.

The cooling fin 70 is configured of a plurality of fin plate portions 72 provided on the outer surface of a rectangular reference plate portion 71. The cooling fin 70 is attached to the outer surface of the rear wall portion 51 so as to block a fin aperture 56 formed in the rear wall portion 51 of the base member 50. The fin aperture 56 is a rectangular aperture formed with vertical and horizontal dimensions smaller than those of the reference plate portion 71. The fin aperture 56 is for bringing the electronic part E' mounted on the inner surface of the rear wall portion 51 and reference plate portion 71 of the cooling fin 70 into thermal contact.

An attachment 80 is removably attached to the rear surface of the base member 50. The attachment 80 is interposed between the base member 50 and an attachment wall surface WP when the base member 50 is attached to the attachment wall surface WP and, as well as accommodating the cooling fin 70 between the rear wall portion 51 and attachment wall surface WP, is for securing a ventilation path 57 for releasing heat. An attachment 80 having an attachment base portion 81 of a rectangular form equivalent to that of the rear wall portion 51 of the base member 50, and cover plate portions 82 protruding toward the interior from both sides of the attachment base portion 81, is applied in the second embodiment. By the attachment 80 being attached to the outer surface of the rear wall portion 51 via the protruding edge surface of each cover plate portion 82, the ventilation path 57 is defined in the up-down direction between the attachment 80 and the rear wall portion 51. A cooling fan CF for circulating air around the ventilation path 57 is annexed to the upper edge portion of the ventilation path 57.

The cover member 60, as shown in Figs. 6 to 8, has a size such as to block the front surface aperture of the base member 50, and secures an accommodation space for accommodating the electronic part E' between itself and the base member 50. In the second embodiment, a cover member 60 wherein a front wall portion 61 forming a rectangular plate form and a peripheral wall portion 62 provided on the periphery of the front wall portion 61 are formed integrally is shown as an example. The peripheral wall portion 62 is a portion protruding toward the rear from the whole periphery of the front wall portion 61. The peripheral wall portion 62 is formed in such a way as to be a continuation of each of the upper wall portion 52, side wall portions 53 , and bottom wall portion 54 when the base member 50 is covered by the cover member 60.

In the cover member 60, a depressed portion 63 is formed in the front wall portion 61, and a duct cover 90 is disposed in the depressed portion 63.

The depressed portion 63 is a depressed place formed in an upward direction from the central portion of the bottom edge of the front wall portion 61. While the depressed portion 63 has a front wall 64, a top wall 65, and a left and right pair of side walls 66, the bottom surface is opened downward. The distance from the front wall portion 61 of the cover member 60 to the front wall 64 of the depressed portion 63 is the same over the whole region of the depressed portion 63. As is also clear from Fig. 8, the front wall portion 61 of the cover member 60, the front wall 64 of the depressed portion 63, the top wall 65 of the depressed portion 63, and the side walls 66 of the depressed portion 63, are formed so as to have approximately the same thickness as each other.

The ventilation opening 67 is formed in the top wall 65 of the depressed portion 63. The ventilation opening 67 is a slit-like aperture, horizontally long in the left-right direction, and is formed in such a way as to vertically penetrate the top wall 65. The ventilation opening 67 is provided in such a way as to be positioned lower than the exhaust opening 55 formed in the rear wall portion 51 of the base member 50 when the housing 101 is disposed in an upright condition.

The duct cover 90 is for defining a ventilation duct D' between itself and the depressed portion 63 of the cover member 60. A duct cover 90 forming a plate form with an external form that can be fitted to the aperture edge portion of the depressed portion 63 is applied in the second embodiment. The duct cover 90 is attached to the cover member 60 in a condition in which a gap is maintained between the duct cover 90 and the front wall 64 of the depressed portion 63, and the opened bottom surface of the depressed portion 63 is left open as a ventilation hole 68. The front surface of the duct cover 90 is positioned in the same plane as the front surface of the cover member 60, configuring a flat surface continuous with the front surface of the cover member 60.

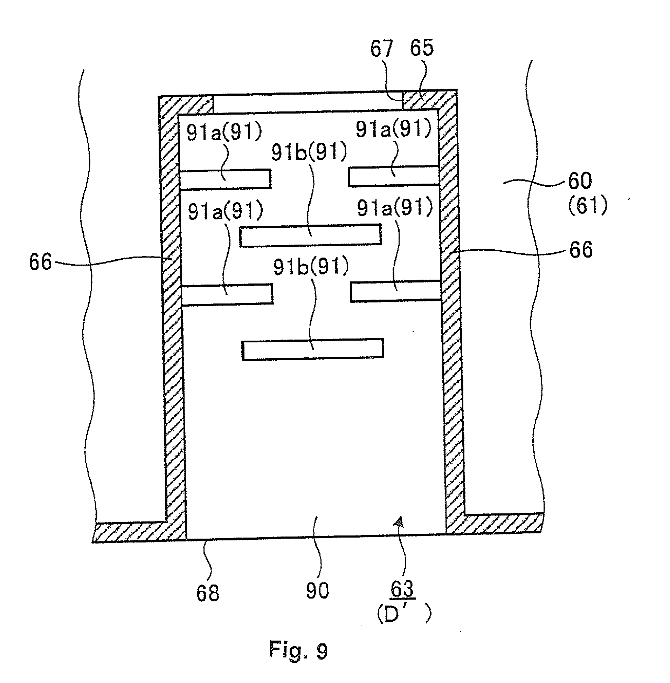

In the duct cover 90, a plurality of dividing walls 91 are provided on the inner surface opposing the depressed portion 63 of the cover member 60. The dividing walls 91 configure a maze between the ventilation opening 67 formed in the top wall 65 of the cover member 60 and the ventilation hole 68 positioned below the ventilation opening 67, wherein the ventilation opening 67 and ventilation hole 68 are communicated between by detouring to the left or right. Specifically, two first dividing walls 91a of a small length are arranged in parallel in a horizontal direction in positions below the lower end edge of the ventilation opening 67, as shown in Fig. 9. A gap is maintained between the first dividing walls 91a. Next, one second dividing wall 91b with a large length is disposed in a horizontal direction in a position below the first dividing walls 91a in such a way as to cover the gap maintained between the first dividing walls 91a from below. Each end portion of the second dividing wall 91b is positioned in a central portion of one of the first dividing walls 91a. Subsequently, two first dividing walls 91a are again arranged in parallel in positions below the second dividing wall 91b, and a second dividing wall 91b is disposed below the first dividing walls 91a. Owing to the heretofore described configuration, it is necessary to pass around four rows of dividing walls 91 to the left or right to reach the ventilation opening 67 from the ventilation hole 68.

The cover member 60 configured as heretofore described, by the peripheral wall portion 62 being joined to each of the upper wall portion 52, side wall portions 53 , and bottom wall portion 54 of the base member 50, configures the housing 101 of the inverter in which an accommodation space for the electronic part E' is secured between the cover member 60 and base member 50. Although not shown in the drawings, it is preferable that water tightness is secured by a gasket being interposed between the bonding surfaces of the peripheral wall portion 62 of the cover member 60 and each of the wall portions 52, 53, and 54 of the base member 50.

Herein, in this inverter, the interior and exterior of the housing 101 are in constant communication via the ventilation hole 68, ventilation duct D', and ventilation opening 67 formed in the top wall 65 of the depressed portion 63 secured between the duct cover 90 and cover member 60, even when water tightness is secured between the bonding surfaces of the cover member 60 and base member 50. Also, the interior and exterior of the housing 101 are in a condition of constant communication via the exhaust opening 55 formed in the rear wall portion 51 of the base member 50. Consequently, when the electronic part E' emits heat due to the inverter being driven, not only is the heat released through the cooling fin 70, but also, while air flows into the interior of the housing 101 through the ventilation hole 68, ventilation duct D', and ventilation opening 67, air in the interior of the housing 101 is expelled to the exterior through the exhaust opening 55, and there is no danger of causing a situation wherein heat is shut up in the interior of the housing 101.

In particular, in the second embodiment, the cooling fan CF is annexed to the ventilation path 57 in which the exhaust opening 55 is opened. Consequently, as negative pressure is created in the ventilation path 57 by the cooling fan CF being driven, and air in the interior of the housing 101 is sucked into the ventilation path 57 via the exhaust opening 55, the heretofore described advantage is still more marked. In this case, according to the inverter, as the ribs 55a are provided on the aperture edge portion of the exhaust opening 55, there is no danger of water, such as rain water, leaking into the ventilation path 57 easily reaching the interior of the housing 101.

Moreover, while the ventilation duct D' communicating between the interior and exterior of the housing 101 opens onto the interior of the housing 101 via the ventilation opening 67 provided in the upper portion of the ventilation duct D', the ventilation duct D' communicates with the exterior of the housing 101 via the ventilation hole 68 provided in the lower portion of the ventilation duct D'. Furthermore, the plurality of dividing walls 91 that cause detours between the ventilation opening 67 and ventilation hole 68 are provided in the interior of the ventilation duct D'. Consequently, even when a jet of water is sprayed from the front or side of the cover member 60, there is no danger of a situation occurring wherein the jet of water reaches the interior of the housing 101. A jet of water leaking into the interior of the ventilation duct D' from the ventilation hole 68 is expelled to the exterior by dripping from the ventilation hole 68 as appropriate, and it does not happen either that the jet of water continuously builds up in the interior of the ventilation duct D'.

Because of this, it is possible to provide a higher waterproofing performance in the inverter, without causing any problem due to heat emitted by the electronic part E'.

Although an inverter is given as an example of the electronic device in the second embodiment, it is possible to apply the invention to another electronic device too, provided that it is an electronic device that accommodates the electronic part E' in the interior of the housing 101.

Also, in the second embodiment, as a maze through which the ventilation opening 67 is reached from the ventilation hole 68 is configured by disposing the dividing walls 91 in the interior of the ventilation duct D' , it is possible to secure greater waterproofing. However, it is possible to secure sufficient waterproofing without providing the maze formed by the dividing walls 91, provided that the ventilation opening 67 is formed in a position higher than the ventilation hole 68.

Furthermore, in the second embodiment, the ventilation duct D' is provided in only the front wall portion 61 of the cover member 60 configuring the housing 101, but the ventilation duct may be provided in only the side wall portions 53, or provided in both the front wall portion 61 and side wall portions 53 , provided that it is provided somewhere other than in the upper wall portion 52.

Further still, in the second embodiment, the ribs are provided on the whole perimeter of the aperture edge portion of the exhaust opening 55 but, this not being necessarily limiting, it is sufficient that the ribs are provided only in a region positioned on the upper edge of the exhaust opening in the exterior of the housing.

### Third Embodiment

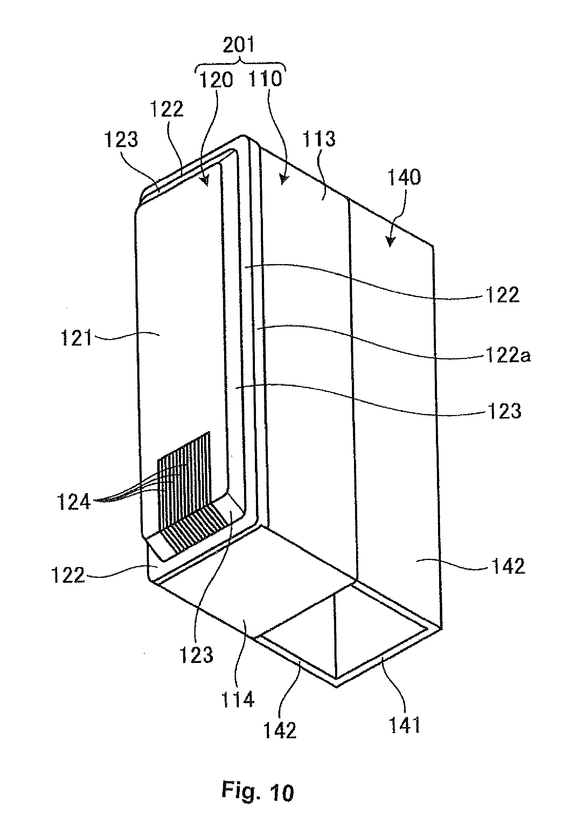

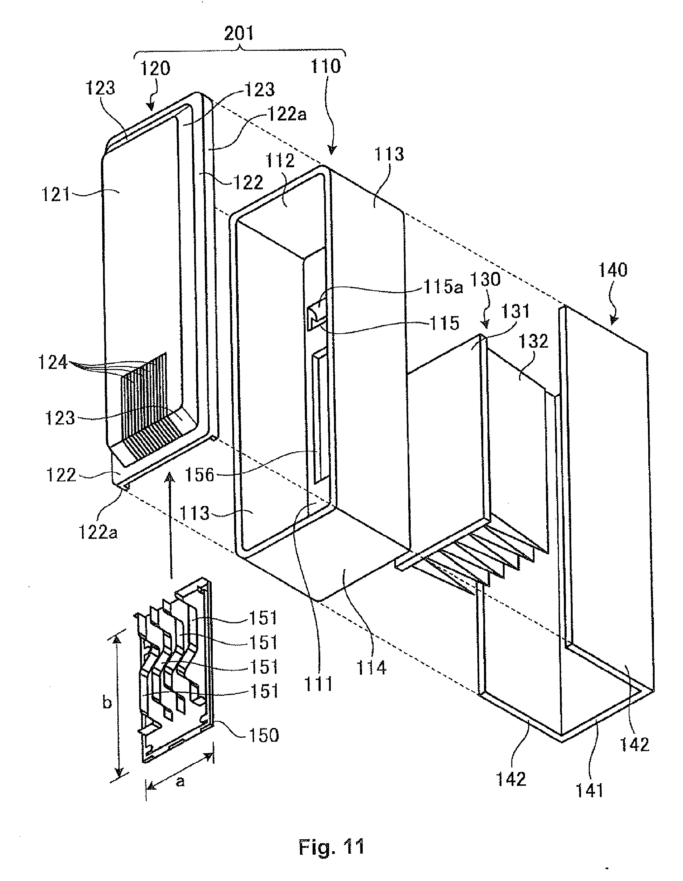

Figs. 10 and 11 show an external appearance of an electronic device, which is a third embodiment of the invention. The electronic device shown as an example here is an inverter that converts direct current to alternating current, and configures a housing 201 including a base member 110 and a cover member 120.

The base member 110, as shown in Figs. 10 to 12, forms a hollow cuboid form whose front surface is opened, and is configured vertically long, with the height dimension being large in comparison with the width dimension in the left-right direction and depth dimension in the front-back direction. In the base member 110, the inner surface of a rear wall portion (a surface member opposing a front wall portion (surface member) 121 of the housing 201, in which ventilation hole slits 124, to be described hereafter, are provided) 111 positioned in the rear surface is a part mounting surface for mounting an electronic part E" . In the base member 110, an upper wall portion 112, left and right side wall portions 113, and bottom wall portion 114 are formed integrally with the rear wall portion 111 so as to cover the periphery of the electronic part E" .

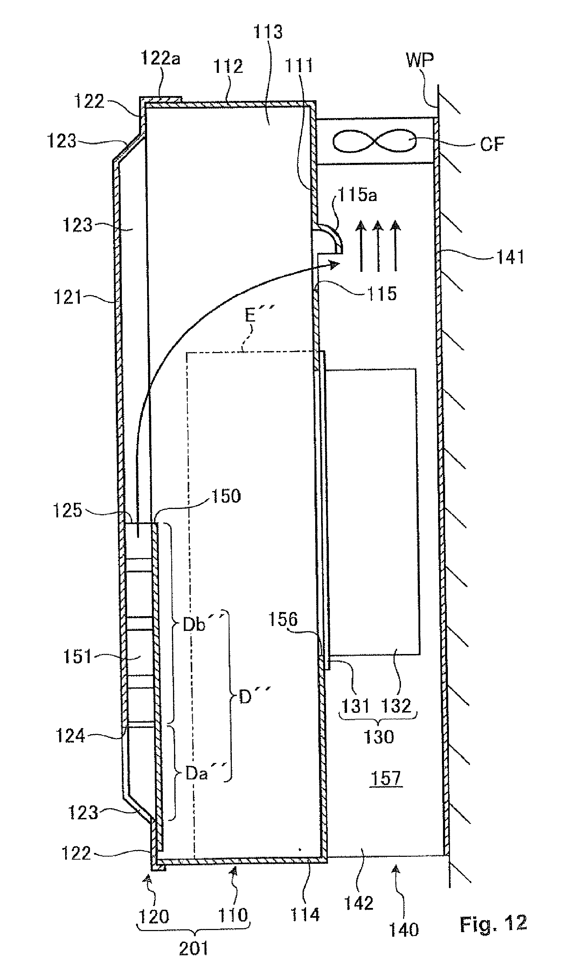

As shown in Figs. 11 and 12, an exhaust opening 115 is provided in the upper edge portion of the rear wall portion 111 of the base member 110, and a cooling fin 130 is attached to the central portion of the rear wall portion 111. The exhaust opening 115 is a slit-like aperture, horizontally long in the left-right direction. The exhaust opening 115 is formed in such a way as to penetrate the rear wall portion 111 from front to back. A rib 115a is provided integrally with the rear wall portion 111 on the upper edge portion of the exhaust opening 115. The rib 115a protrudes in such a way as to curve progressively downward from the rear surface of the rear wall portion 111, and functions as an eave covering the upper portion of the exhaust opening 115.

The cooling fin 130 is configured of a plurality of fin plate portions 132 provided on the outer surface of a rectangular reference plate portion 131. The cooling fin 130 is attached to the outer surface of the rear wall portion 111 so as to block a fin aperture 156 formed in the rear wall portion 111 of the base member 110. The fin aperture 156 is a rectangular aperture formed with vertical and horizontal dimensions smaller than those of the reference plate portion 131. The fin aperture 156 is for bringing the electronic part E" mounted on the inner surface of the rear wall portion 111 and reference plate portion 131 of the cooling fin 130 into thermal contact.

An attachment 140 is removably attached to the rear surface of the base member 110. The attachment 140 is interposed between the base member 110 and the attachment wall surface WP when the base member 110 is attached to the attachment wall surface WP and, as well as accommodating the cooling fin 130 between the rear wall portion 111 and attachment wall surface WP, is for securing a ventilation path 157 for releasing heat. An attachment 140 having an attachment base portion 141 of a rectangular form equivalent to that of the rear wall portion 111 of the base member 110, and cover plate portions 142 protruding toward the interior from both sides of the attachment base portion 141, is applied in the third embodiment. By the attachment 140 being attached to the outer surface of the rear wall portion 111 via the protruding edge surface of each cover plate portion 142, the ventilation path 157 is defined in the up-down direction between the attachment 140 and the rear wall portion 111. The cooling fan CF for circulating air around the ventilation path 157 is annexed to the upper edge portion of the ventilation path 157.

The cover member 120, as shown in Figs. 10 to 12, has a size such as to block the front surface aperture of the base member 110, and secures an accommodation space for accommodating the electronic part E" between itself and the base member 110. In the third embodiment, a cover member 120 wherein a rectangular front wall portion 121, a peripheral wall portion 122 provided on the periphery of the front wall portion 121, and an inclined wall portion 123 provided between the front wall portion 121 and peripheral wall portion 122 are formed integrally is shown as an example. The front wall portion 121 forms a rectangular plate form with vertical and horizontal dimensions smaller than those of the front surface aperture of the base member 110. The peripheral wall portion 122 is a frame-like portion provided on the whole periphery of the front wall portion 121, and is configured in such a way as to form a rectangular form whose external form is slightly larger than the front surface aperture of the base member 110. A lip 122a is formed in each of regions in the peripheral wall portion 122 corresponding to the upper wall portion 112 and left and right side wall portions 113 of the base member 110. The lips 122a are portions protruding toward the rear from the edge portion of the peripheral wall portion 122. The lips 122a are disposed stacked upon the outer surface of the front edge portions of the upper wall portion 112 and side wall portions 113 when the front surface aperture of the base member 110 is covered by the cover member 120. The inclined wall portion 123 is a portion that progressively inclines rearward toward the exterior from each of the four edge portions of the front wall portion 121, and is provided in such a way as to be continuous between the front wall portion 121 and peripheral wall portion 122. The front wall portion 121, peripheral wall portion 122, and inclined wall portion 123 are formed in such a way that each has approximately the same thickness.

In the cover member 120, a plurality of the ventilation hole slits 124 are formed in a region extending from the lower inclined wall portion 123, disposed inclined so as to face downward, to the lower portion of the front wall portion 121. Each of the ventilation hole slits 124 is a thin aperture in the up-down direction, and is formed in such a way as to penetrate the front wall portion 121 and inclined wall portion 123. The ventilation hole slits 124 have the same width and length as each other, and are arranged in parallel at equal intervals in the left-right direction.

A duct cover 150 is disposed on the inner surface of the cover member 120, as shown in Fig. 12. The duct cover 150 is for defining a ventilation duct D" between itself and the inner surface of the cover member 120, as shown in Figs. 12 to 14. A duct cover 150 forming a rectangular plate form is applied in the third embodiment. A left-right dimension a of the duct cover 150 is set to be larger than the front wall portion 121 of the cover member 120, so that the duct cover 150 can be brought into contact with the peripheral wall portion 122 positioned on each of the left and right of the cover member 120. An up-down dimension b of the duct cover 150 is set to a size such that the upper end edge of the duct cover 150 is above the upper end edge of the ventilation hole slits 124, and sufficiently below the lower edge of the exhaust opening 115 formed in the rear wall portion 111, when the lower end portion of the duct cover 150 is brought into contact with the peripheral wall portion 122 positioned at the bottom of the cover member 120. The ventilation duct D" defined by the cover member 120 and duct cover 150 communicates with the exterior of the housing 201, with the plurality of ventilation hole slits 124 as ventilation holes. Meanwhile, the ventilation duct D" communicates with the interior of the housing 201 via a ventilation opening 125 formed between the upper end portion of the duct cover 150 and the inner surface of the cover member 120. The ventilation opening 125 of the ventilation duct D" is set in a position lower than the lower edge of the exhaust opening 115.

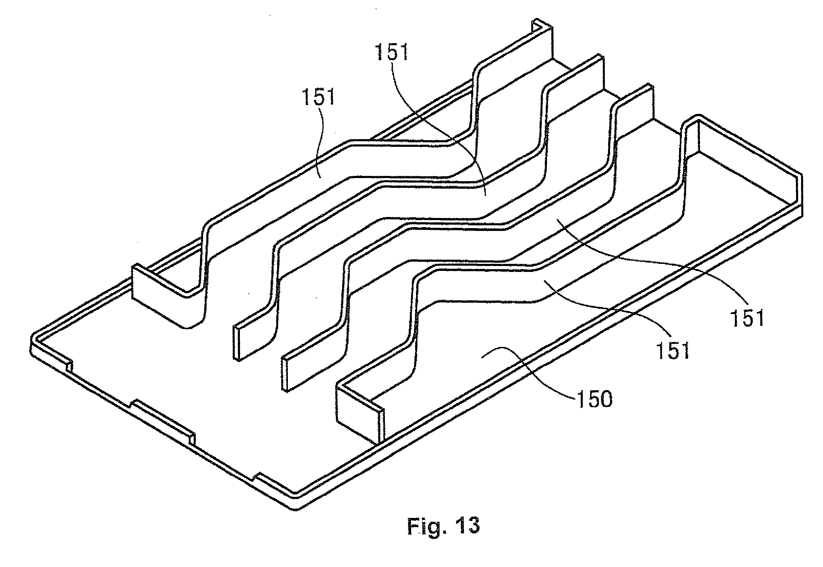

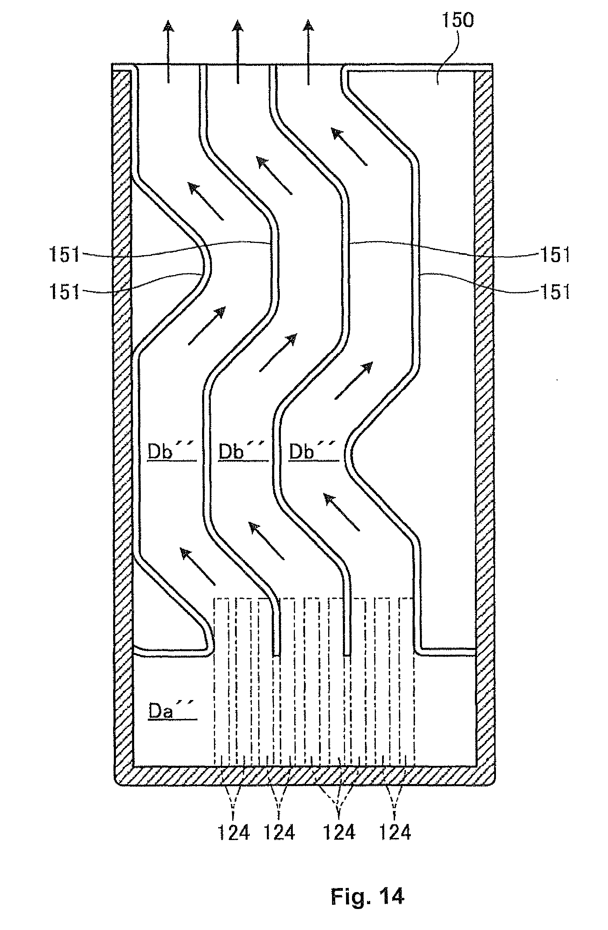

In the duct cover 150, a plurality of dividing walls 151 are provided on an inner surface opposing the cover member 120. The dividing walls 151 are for configuring a maze between the ventilation opening 125 formed in the top wall of the cover member 120 and the ventilation hole slits 124 positioned below the ventilation opening 125, wherein the ventilation opening 125 and ventilation hole slits 124 are communicated between by detouring to the left or right. Specifically, a maze wherein the ventilation hole slits 124 and ventilation opening 125 are communicated between while detouring to the left or right is configured by disposing the thin plate-like dividing wall 151, which has an irregular form on both front and rear surfaces from being bent back and forth, in the up-down direction, and arranging a plurality of the dividing walls 151 in parallel to the left and right, maintaining a constant gap between them, as shown in Figs. 13 and 14.

As is also clear from Fig. 14, the lower end of each of the dividing walls 151 terminates above the lower end of the duct cover 150. Because of this, one large duct space portion Da" is defined in the lower end portion of the ventilation duct D", while split duct portions Db" split into a plurality by the dividing walls 151 are defined in the upper end portion of the ventilation duct D". In each of the split duct portions Db", the upper end aperture position and lower end aperture position are provided out of alignment with each other to the left and right. Also, each dividing wall 151 is bent more largely than the size of the gap with the adjacent dividing wall 151. Because of this, as no linear path exists in a vertical direction in any of the split duct portions Db" , the dividing wall 151 inevitably exists in the way when proceeding in the vertical direction. That is, it is necessary to detour to the left or right to reach the ventilation opening 125 from the ventilation hole slits 124.

The cover member 120 configured as heretofore described, by covering the front surface aperture of the base member 110, and disposing the lips 122a stacked on the outer surface of the front edge portions of the upper wall portion 112 and side wall portions 113, configures the housing 201 of the inverter in which an accommodation space for the electronic part E" is secured between the cover member 120 and base member 110. Although not shown in the drawings, it is preferable that water tightness is secured by a gasket being interposed between the bonding surfaces of the peripheral wall portion 122 of the cover member 120 and each of the wall portions 112, 113, and 114 of the base member 110.

Herein, in this inverter, the interior and exterior of the housing 201 are in constant communication via the ventilation hole slits 124 of the front wall portion 121, ventilation duct D", and ventilation opening 125, even when water tightness is secured between the bonding surfaces of the cover member 120 and base member 110. Also, the interior and exterior of the housing 201 are in a condition of constant communication via the exhaust opening 115 formed in the rear wall portion 111 of the base member 110. Consequently, when the electronic part E" emits heat due to the inverter being driven, not only is the heat released through the cooling fin 130, but also, while air flows into the interior of the housing 201 through the ventilation hole slits 124, ventilation duct D", and ventilation opening 125, air in the interior of the housing 201 is expelled to the exterior through the exhaust opening 115, and there is no danger of causing a situation wherein heat is shut up in the interior of the housing 201.

In particular, in the third embodiment, the cooling fan CF is annexed to the ventilation path 157 in which the exhaust opening 115 is opened. Consequently, as negative pressure is created in the ventilation path 157 by the cooling fan CF being driven, and air in the interior of the housing 201 is sucked into the ventilation path 157 via the exhaust opening 115, the heretofore described advantage is still more marked. In this case, according to the inverter, as the rib 115a is provided on the aperture edge portion of the exhaust opening 115, it is possible to effectively prevent water, such as rain water, leaking into the ventilation path 157 from easily reaching the interior of the housing 201.

Moreover, while the ventilation duct D" communicating between the interior and exterior of the housing 201 opens onto the interior of the housing 201 via the ventilation opening 125 provided in the upper portion of the ventilation duct D" , the ventilation duct D" communicates with the exterior of the housing 201 via the ventilation hole slits 124 provided in the lower portion of the ventilation duct D". Furthermore, the plurality of dividing walls 151 that cause detours between the ventilation opening 125 and ventilation hole slits 124 are provided in the interior of the ventilation duct D". Consequently, even when a jet of water is sprayed from the front or side of the cover member 120, there is no danger of a situation occurring wherein the jet of water reaches the interior of the housing 201. A jet of water leaking into the interior of the ventilation duct D" from the ventilation hole slits 124 is expelled to the exterior by dripping from the ventilation hole slits 124 as appropriate, and it does not happen either that the jet of water continuously builds up in the interior of the ventilation duct D".

Because of this, it is possible to provide a higher waterproofing performance in the inverter, without causing any problem due to heat emitted by the electronic part E".

Although an inverter is given as an example of the electronic device in the third embodiment, it is possible to apply the invention to another electronic device too, provided that it is an electronic device that accommodates the electronic part E" in the interior of the housing 201.

Also, in the third embodiment, as a maze through which the ventilation opening 125 is reached from the ventilation hole slits 124 is configured by disposing the dividing walls 151 in the interior of the ventilation duct D" , it is possible to secure greater waterproofing. However, it is possible to secure sufficient waterproofing without providing the maze formed by the dividing walls 151, provided that the ventilation opening 125 is formed in a position higher than the ventilation hole slits 124.

Furthermore, in the third embodiment, the ventilation duct D" is provided in only the front wall portion 121 of the cover member 120 configuring the housing 201, but the ventilation duct may be provided in only the side wall portions 113, or provided in both the front wall portion 121 and side wall portions 113, provided that it is provided somewhere other than in the upper wall portion 112.

## Claims

1. An electronic device that accommodates an electronic part in the interior of a housing,
wherein
a ventilation duct is defined in a vertical direction in a surface member configuring a wall of the housing, and a ventilation hole that allows the ventilation duct to communicate with the exterior of the housing is formed in the lower end portion of the ventilation duct, and a ventilation opening that allows the ventilation duct to communicate with the interior of the housing is formed in a position higher than the ventilation hole.

2. The electronic device according to claim 1, wherein
a maze reaching the ventilation opening from the ventilation hole is configured by arranging at least one dividing wall in the interior of the ventilation duct.

3. The electronic device according to claim 2, wherein
the maze is configured by providing a plurality of dividing walls, each extending in a horizontal direction, the dividing walls being positioned in different vertical positions, while each dividing wall comprises at least one gap, the gaps being arranged such that the horizontal extension of the gaps in one dividing wall in a first vertical position is different to the horizontal extension of the gaps in another dividing wall in a second, directly adjacent vertical position.

4. The electronic device according to claim 2, wherein
the maze is comprising a plurality of dividing walls, being curved and extending also in a vertical direction such that a curved path between each two of the dividing walls is formed.

5. The electronic device according to one of the preceding claims, wherein
the housing is configured as a cuboid with a height being larger than the width dimension in the horizontal direction, and the ventilation duct is defined in a surface member configuring the front surface of the housing.

6. The electronic device according one of the preceding claims, wherein
a duct cover is provided on the inner surface of a surface member configuring a wall of the housing, the ventilation duct is defined between the surface member and duct cover, and the ventilation hole is formed in the lower end portion of the surface member.

7. The electronic device according to claim 6, wherein
the ventilation hole is configured by providing a plurality of rectangular holes, and the ventilation opening is configured by providing only one rectangular hole in the duct cover, an aperture area of each of the plurality of rectangular holes of the ventilation hole being smaller than an aperture area of the one rectangular hole of the ventilation opening.

8. The electronic device according to claim 7, wherein
a water-impermeable plate is provided and positioned such that it covers the front region of the ventilation hole.

9. The electronic device according to claim 6, wherein
the ventilation hole comprises a plurality of slits, extending in the vertical direction and being arranged parallel to each other and being arranged at least partly in a surface being inclined such that it at least partly faces the bottom of the housing, and wherein the ventilation opening is formed between the surface member and the upper edge portion of the duct cover.

10. The electronic device according to claim 9, wherein
an exhaust opening communicating between the interior and exterior of the housing is formed in the upper end portion of a surface member opposing the surface member of the housing in which the ventilation hole is provided.

11. The electronic device according to one of the claims 1 to 5, wherein
a duct cover is provided on the outer surface of a surface member configuring a wall of the housing, the ventilation duct is defined between the surface member and duct cover, the ventilation opening is formed in the surface member, and the ventilation hole is formed between the surface member and the lower end portion of the duct cover.

12. The electronic device according to claim 11, wherein
a depressed portion having a top wall is formed in the outer surface of the surface member, the ventilation duct is defined by the duct cover covering the depressed portion, and the ventilation opening is provided in the top wall of the depressed portion.

13. The electronic device according to claim 11 or 12, wherein
an exhaust opening communicating between the interior and exterior of the housing is formed in the upper end portion of a surface member opposing the surface member of the housing in which the ventilation opening is provided.

14. The electronic device according to claim 10 or 13, wherein
the exhaust opening is formed in a position higher than the ventilation opening.

15. The electronic device according to claim 10, 13 or 14, wherein
a rib is installed protruding in a region positioned on the upper edge of the exhaust opening in at least the exterior of the housing.
